# FASCICULE DE BREVET EUROPEEN

(11) **EP 3 317 883 B1**
(45) Date de publication et mention de la délivrance du brevet: **27.02.2019**
(21) Numéro de dépôt: 16733483.8
(22) Date de dépôt: 28.06.2016
(51) Int. Cl.: G21C 13/028, G21C 17/116, G21C 13/036, G21C 1/32, H01B 17/30, G01R 31/02, G21C 17/00

(54) **ASSEMBLAGE DE PENETRATION ELECTRIQUE DE CUVE D'UN REACTEUR NUCLEAIRE**
ELEKTRISCHE DURCHFÜHRUNGSANORDNUNG FÜR EINEN KERNREAKTORBEHÄLTER
ELECTRICAL FEEDTHROUGH ASSEMBLY FOR A NUCLEAR REACTOR VESSEL

(30) Priorité: 30.06.2015 FR 1556144
(43) Date de publication de la demande: 09.05.2018
(73) Titulaire: Société Technique pour l'Energie Atomique, 91190 Villiers Le Bacle (FR)
(72) Inventeur: BRUN, Michel, 13109 Simiane-Collongue (FR)
(74) Mandataire: Cabinet Camus Lebkiri
(86) Numéro de dépôt international: PCT/EP2016/065021
(87) Numéro de publication internationale: WO 2017/001409

(56) Documents cités:
- WO-A1-2013/158697
- FR-A1- 2 258 028
- FR-A1- 3 011 134
- US-A- 4 168 394

## Description

### DOMAINE TECHNIQUE DE L'INVENTION

L'invention se rapporte au domaine des assemblages de pénétrations électrique (EPA pour electrical penetration assembly) traversant les cuves des réacteurs nucléaires.

L'invention trouve une application particulièrement intéressante dans le domaine des réacteurs nucléaires intégrés et des petits réacteurs modulaires également appelé SMR (pour Small & Modular Reactor en langue anglaise) comportant de nombreux actionneurs/capteurs en cuve créant des besoins spécifiques de pénétrations électriques. Une application dans les réacteurs pressurisés conventionnels est possible en remplacement des doigts de gants.

### ETAT DE LA TECHNIQUE ANTERIEURE

Ces pénétrations électriques de cuve doivent répondre à plusieurs critères. Elles doivent être démontables rapidement, souples pour être compatibles avec les dilatations différentielles entre la cuve et les internes, d'un diamètre utile significatif (de l'ordre de plusieurs centimètres) afin d'être compatible avec le nombre et la puissance des liaisons électriques à assurer dans la cuve.

Une première solution connue consiste à mettre en place au sein de la cuve une bride d'instrumentation dédiée et démontable regroupant les nombreux doigts de gants requis pour un SMR pour permettre leur dépose en une seule opération. Une telle solution est décrite notamment dans les documents US 20130287157 et US 2014198891. Le défaut de cette solution est l'augmentation importante du développé de l'extension de la seconde barrière de confinement tant pour les doigts de gants que pour les capteurs/actionneurs. Une telle architecture a donc pour conséquence : d'augmenter les risques de fuite, de multiplier les zones et les pièces soumises à des réglementations de conception, de fabrication, d'inspection et de contrôle en service.

Afin de ne pas ajouter d'extension de seconde barrière, d'autres solutions proposées consistent à transposer les architectures et les technologies existantes pour les traversées d'enceinte de confinement utilisant de la connectique hermétique comme le propose le document WO 2013/158697. En effet, les technologies de traversées électriques hermétiques mises en oeuvre pour les pénétrations d'enceinte, telles que les technologies de vitrocéramique précontrainte ou de céramique brasées par exemple, résistent aux contraintes de température et de pression du fluide primaire.

Toutefois, les contraintes et les exigences de conception requises au niveau des pénétrations d'enceinte, situées sur la troisième barrière de confinement qui ne sont sollicitées en pression et en température qu'uniquement lors d'un accident, sont moins élevées que les contraintes et des exigences de conception requises au niveau des pénétrations de la cuve du réacteur qui sont sollicitées en permanence en pression et en température par le fluide primaire et dont la défaillance est une cause initiale d'incident critique, voire d'accident (selon le diamètre équivalent de fuite en cas de défaillance).

Par conséquent, il n'est pas évident pour l'homme du métier de transposer toutes les solutions existantes et connues des pénétrations électriques d'enceinte aux pénétrations électriques de cuve car elles restent insuffisantes en terme de sûreté.

En particulier, les pénétrations électriques connues basées sur une technologie de vitrocéramique précontrainte ou de céramique brasée pour réaliser une herméticité et une isolation électrique, ne respectent pas la caractéristique requise pour les matériaux utilisés en seconde barrière de confinement. En effet, les matériaux de seconde barrière doivent présenter des caractéristiques de ductilité et de ténacité particulières. Or le caractère non ductile et fragile du verre, de la vitrocéramique ou de la céramique rend difficile leur utilisation directe sur le périmètre de la seconde barrière réglementaire sous pression primaire contrairement à ce que suggère le document WO 2013/158697.

En effet, dans le domaine des réacteurs intégrés et des petits réacteurs modulaires (SMR), il est un objectif de réduire dès la conception les causes de brèches importantes. Par conséquent l'homme du métier cherchant à réaliser des pénétrations électriques de cuve selon ces critères ne serait pas incité à utiliser directement des connecteurs en verre, vitrocéramique ou céramique, malgré que ces technologies respectent les exigences de pression/température du liquide primaire, car la défaillance brutale d'une traversée électrique d'un diamètre significatif (typiquement entre 30mm et 50mm de diamètre pour une liaison électrique avec une vingtaine de points de contact) utilisant un connecteur étanche en verre, en vitrocéramique ou en céramique au contact permanent des conditions du primaire serait contraire à l'esprit des réglementations applicables à la seconde barrière de confinement d'un réacteur à eau pressurisée.

### EXPOSE DE L'INVENTION

Dans ce contexte l'invention cherche à proposer un assemblage de pénétration électrique de cuve d'un réacteur nucléaire permettant de s'affranchir d'une extension de seconde barrière de confinement et permettant de respecter l'esprit des réglementation de conception imposés dans le domaine des réacteurs pressurisés et des SMR en particulier, à savoir la prévention de fuites primaires et la limitation des conséquences de défaillances éventuelles.

A cette fin, l'invention a pour objet un assemblage de pénétration électrique de cuve d'un réacteur nucléaire apte à être installé dans un orifice de cuve de réacteur nucléaire, ledit assemblage de pénétration électrique comportant:
- un corps de pénétration comportant :
   - une première extrémité apte à être positionnée à l'intérieur de la cuve ;
   - une deuxième extrémité apte à être positionnée à l'extérieur de la cuve ;
- un connecteur électrique étanche formant une première herméticité de l'assemblage de pénétration électrique, ledit connecteur électrique étanche rendant hermétique le corps de pénétration au niveau de la première extrémité ;
- une bride porte-traversées comportant une pluralité de traversées électriques unitaires, chaque traversée électrique unitaire permettant le passage d'un unique conducteur électrique assurant la continuité des liaisons électriques, chaque traversé électrique unitaire étant isolée unitairement par un isolant individuel formant une deuxième herméticité de l'assemblage de pénétration électrique, lesdites traversées électriques unitaires rendant hermétique le corps de pénétration au niveau de la deuxième extrémité ;
- un dispositif d'anti-éjection formé par la coopération d'un étranglement ménagé au niveau de chaque traversée électrique unitaire et d'un épaulement présentant des dimensions supérieures aux dimensions de l'étranglement de chaque traversée électrique unitaire et ménagé sur chacun des conducteurs électriques desdites traversées unitaires.

L'assemblage de pénétration électrique selon l'invention peut également présenter une ou plusieurs des caractéristiques ci-dessous prises individuellement ou selon toutes les combinaisons techniquement possibles :
- l'assemblage de pénétration électrique comporte des moyens pour solidariser de manière étanche l'assemblage de pénétration électrique à l'extérieur de ladite cuve du réacteur ;
- lesdits isolants individuels sont des isolants en céramique ou en vitrocéramique précontrainte ;
- ledit connecteur électrique étanche est un connecteur électrique présentant un isolant en céramique ou un isolant en vitrocéramique précontrainte ;
- le matériau de l'isolant du connecteur électrique étanche est différent du matériau formant les isolants individuels ;
- l'assemblage de pénétration électrique comporte des moyens pour détecter une défaillance d'étanchéité des traversées unitaires ;
- le corps de pénétration électrique est sous pression d'un gaz neutre et en ce que les moyens pour détecter une défaillance d'étanchéité sont formés par un dispositif de détection détectant une augmentation de pression en aval des traversées unitaires ; avantageusement, le corps de pénétration est sous une pression de gaz neutre de l'ordre de 1 à 10 MPa ;
- le corps de pénétration comporte au moins une partie rigide et une partie flexible apte à se déformer au moins selon une direction ;
- l'assemblage de pénétration électrique comporte des moyens pour limiter le débit de fuite en cas de défaillance du connecteur électrique étanche cumulée avec la défaillance d'au moins un isolant individuel ;
- l'assemblage de pénétration électrique comporte un premier moyen pour limiter le débit de fuite, en cas de défaillance du connecteur électrique étanche cumulé à la défaillance d'au moins un isolant individuel, formé par ledit dispositif anti-éjection ménagé au niveau de chacune des traversées électriques unitaires ;
- l'assemblage de pénétration électrique comporte un deuxième moyen pour limiter le débit de fuite, en cas de défaillance du connecteur électrique étanche et de plusieurs traversées électrique unitaires, formé par une pluralité de conduits unitaires ménagés à l'intérieur du corps de pénétration, chaque conduit unitaire étant adapté pour permettre le passage d'un unique conducteur électrique traversant ledit corps de pénétration.

L'invention a également pour objet une cuve de réacteur nucléaire caractérisée en ce qu'elle comporte au moins une traversée électrique selon l'invention.

L'invention a également pour objet un réacteur nucléaire caractérisé en ce qu'il compote une cuve selon l'invention.

Avantageusement, ledit réacteur nucléaire est un réacteur intégré ou un petit réacteur modulaire.

Avantageusement, ledit réacteur nucléaire comporte des moyens pour détecter une défaillance d'étanchéité du connecteur électrique étanche par contrôle de l'isolement des conducteurs électriques par rapport à la masse.

### BREVE DESCRIPTION DES FIGURES

D'autres caractéristiques et avantages de l'invention ressortiront à la lecture de la description qui suit, en référence aux figures annexées.
La figure 1 illustre une vue en section d'une partie de cuve de réacteur nucléaire comportant un premier mode de réalisation d'un assemblage de pénétration électrique de cuve selon l'invention.
La figure 2 illustre de manière plus détaillée une traversée unitaire 142 de l'assemblage de pénétration électrique de cuve illustrée à la figure 1.
La figure 3 illustre une vue en section d'une partie de cuve de réacteur nucléaire comportant un deuxième mode de réalisation d'un assemblage de pénétration électrique de cuve selon l'invention.

Dans toutes les figures, les éléments communs portent les mêmes références sauf précision contraire.

Les termes amont et aval utilisés dans la demande de brevet sont définis en considérant le sens d'écoulement du fluide primaire en cas de fuite, c'est-à-dire de l'intérieur vers l'extérieur de la cuve 10.

### DESCRIPTION DETAILLEE D'UN MODE DE REALISATION

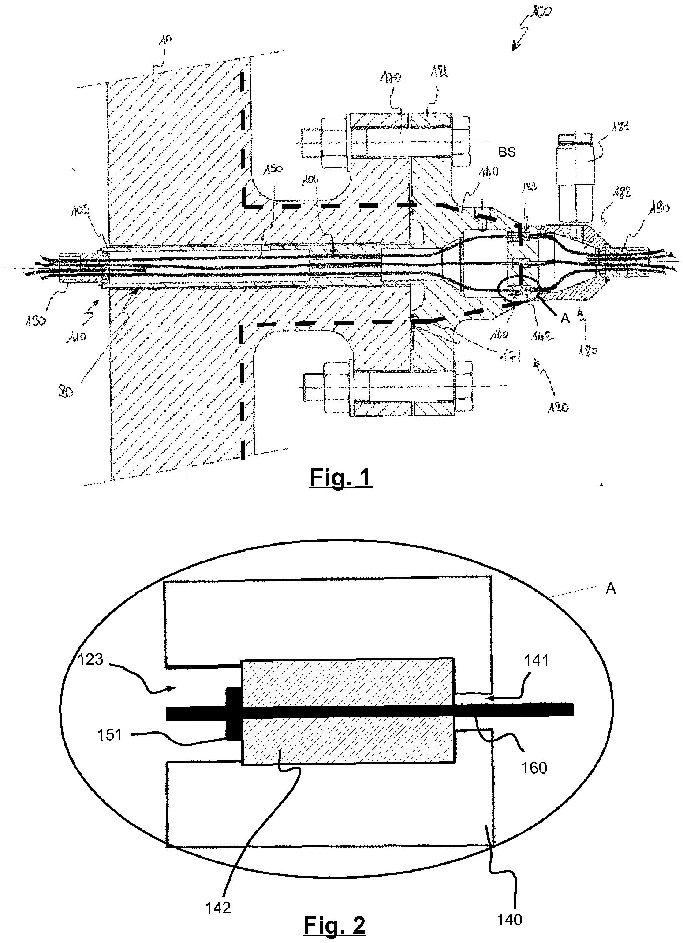

La figure 1 illustre une vue en coupe d'un premier mode de réalisation d'une traversée électrique 100 selon l'invention installée dans un orifice 20 d'une cuve 10 d'un réacteur nucléaire, de type intégré ou encore SMR.

L'assemblage de pénétration électrique de cuve (V-EPA pour Vessel Electrical Penetration Assembly) 100 selon l'invention comporte un corps de pénétration 105 sensiblement de forme cylindrique présentant une première extrémité 110, dite extrémité interne, destinée à être positionnée à l'intérieur de la cuve 10 du réacteur nucléaire et une deuxième extrémité 120, dite extrémité externe, destinée à être positionnée à l'extérieur de la cuve 10 du réacteur.

Un connecteur étanche 130 est solidarisé, par exemple au moyen d'une soudure étanche, au niveau de l'extrémité interne 110 du corps de pénétration 105 soumise aux conditions de pression et de température du liquide primaire. Ce connecteur étanche 130 forme ainsi une première herméticité de la pénétration 100.

Le diamètre du connecteur 130 et le nombre de broches le constituant est fixé par le besoin fonctionnel (i.e. en fonction du nombre de fils et de l'isolation nécessaires). Le connecteur étanche 130 utilisé dans un réacteur nucléaire intégré présente typiquement un diamètre compris entre 30mm et 50mm. Le connecteur étanche 130 est un connecteur qualifié pour tenir aux conditions primaires, y compris sans la présence de l'aboutissant, i.e. le capteur ou l'actionneur normalement raccordé, mais n'est pas soumis à la réglementation applicable aux dispositifs de la seconde barrière.

L'extrémité externe 120 de la pénétration électrique 100 comporte une bride porte-traversées 140 comportant une pluralité de traversées unitaires 123 dans lesquelles une pluralité de conducteurs électriques 160, tels que des broches, sont isolées individuellement par un isolant 142 en vitrocéramique ou en céramique. La bride porte-traversée 140, constitue donc une deuxième herméticité de l'assemblage de pénétration électrique 100.

L'extrémité externe 120 de la pénétration électrique 100 comporte en outre une cellule de détection de fuite et de raccordement 180 raccordée solidairement (par exemple par soudure) à l'extrémité extérieure de la bride porte-traversées 140. La cellule de détection de fuite et de raccordement 180 permet également le montage d'un connecteur standard 190 assurant le raccordement électrique à l'extérieur de la cuve 10. De manière identique au connecteur étanche 130, le connecteur standard étanche 190 est solidarisé, par exemple au moyen d'une soudure étanche, au niveau de l'extrémité externe de la cellule de détection et de raccordement 180.

Le corps de pénétration 105 renferme également une pluralité de câbles électrique 150 assurant le raccordement électrique entre les broches du connecteur étanche 130 d'une part (formant la première herméticité de l'assemblage de pénétration 100) et les connecteurs électriques 160 isolées unitairement par un isolant 142 situées au niveau de la bride porte-traversées 140 (formant la deuxième herméticité de l'assemblage de pénétration). Les câbles électriques 150 à l'intérieur du corps de pénétration sont ainsi rendus indémontables. Les câbles électriques 150 sont par exemple des câbles minéraux qualifiés aux conditions de température du primaire.

A l'intérieur du corps de pénétration 105 est ménagée une pluralité de conduits unitaires 106 (trois conduits étant représentés à la figure 1), chacun des conduits unitaires 106 autorisant le passage d'un unique câble électrique 150. De tels conduits unitaires 106 ménagés à l'intérieur du corps de pénétration 105 permettent avantageusement de limiter le débit de fuite de liquide primaire en cas de défaillance totale de l'ensemble des lignes hermétiques (i.e. connecteur 130 et traversées unitaires 123).

L'assemblage de pénétration électrique 100 comporte des moyens pour assurer le maintien mécanique de celle-ci sur la cuve 10. Avantageusement, les moyens assurant le maintien mécanique sont formés par un flasque d'extrémité 121 agencé au niveau de la deuxième extrémité 120 du corps de pénétration 105, formant ainsi une bride de maintien permettant ainsi de solidariser l'assemblage de pénétration électrique 100 par l'extérieur de la cuve 10. A cet effet, le flasque d'extrémité 121 coopère avec des éléments de fixation 170 et au moins un joint annulaire 171 permettant de solidariser l'assemblage de pénétration électrique 100 de manière étanche sur la cuve 10. Dans le mode de réalisation illustré à la figure 1, le flasque d'extrémité 121 assurant le maintien et la bride porte traversée 140 forment une pièce monobloc. Toutefois, il est envisagé de pouvoir réaliser séparément ces deux éléments.

Ainsi, l'assemblage de pénétration électrique 100 proposé par l'invention cherche à découpler la fonction de connectique de la « fonction de seconde barrière de confinement », en décalant les exigences de conception liées aux éléments constituant la seconde barrière de confinement sur la bride porte-traversée 140 et tout particulièrement sur la conception particulière des traversées unitaires 123.

Une telle architecture permet ainsi d'avoir un connecteur étanche 130 soumis aux conditions du liquide primaire (i.e. aux conditions de température et de pression du liquide primaire) sans toutefois répondre à la réglementation de conception et de fabrication des éléments constituant la seconde barrière de confinement, ce qui permet d'utiliser avantageusement un connecteur étanche de conception simple, facile à connecter et/ou à déconnecter, et d'éviter une inspection périodique de ce connecteur étanche 130, ainsi que de l'ensemble de la liaison jusqu'au capteur/actionneur difficile d'accès car situé à l'intérieur de la cuve 10.

En effet, la continuité de la seconde barrière de confinement, illustrée sur la figure 1 par la ligne en pointillés référencée BS, est assurée par la bride porte traversée 140 qui respecte les principes que seront explicités par la suite afin de compenser la non ductilité des matériaux utilisés pour la traversée isolante hermétique.

Comme illustré à la figure 2, chaque traversée unitaire 123 de la bride porte-traversée 140 présente au niveau de son extrémité extérieure un étranglement 141 qui permet également de limiter le débit de fuite de la pénétration électrique 100 en cas défaillance au niveau d'une traversée unitaire 123, combinée à une défaillance du connecteur 130 de manière à répondre aux critères de sûreté.

L'assemblage de pénétration électrique 100 selon l'invention comporte un système d'anti-éjection permettant d'éviter toute éjection des broches 160 ou des câbles 150 situés à l'intérieur du corps de pénétration 105. Ce système d'anti-éjection est formé par la présence d'un épaulement 151 au niveau de chaque conducteur électrique 160 des traversées unitaires 123 de la bride porte-traversées 140. Chaque épaulement 151 coopère avec un étranglement 141 en assurant la non éjection de la broche 160 ou du câble 150 même en ruine totale d'un isolant 142 couplé à la fuite du connecteur étanche 130. Pour cela, les dimensions des épaulements 151 au niveau des traversées 123 sont supérieures aux dimensions, et notamment au diamètre, de l'étranglement 141 en sortie des traversées 123.

Avantageusement, les matériaux utilisés pour réaliser l'étanchéité du connecteur étanche 130 de la première herméticité et les isolants unitaires 142 formant la deuxième herméticité sont différents. Ainsi par exemple, il est possible d'utiliser un connecteur isolant 130 avec une technologie céramique et des isolants unitaires 142 utilisant une technologie de vitrocéramique précontrainte. La diversité des matériaux permet de d'améliorer la justification du concept vis-à-vis des défaillances de mode commun.

L'assemblage de pénétration électrique 100 comporte également un moyen de détection apte à détecter une défaillance d'étanchéité du connecteur étanche 130 interne et/ou de son raccordement mécanique au corps de pénétration 105. Les moyens de détection contrôlent l'isolement permanent des liaisons électriques par rapport à la masse. La défaillance du connecteur étanche interne 130 se traduit par un envahissement en liquide primaire du corps de pénétration ce qui occasionnera la perte de l'isolement des liaisons électriques.

L'assemblage de pénétration électrique 100 comporte également un moyen de détection permettant de détecter une défaillance d'étanchéité d'au moins une traversée unitaire 123 de la bride porte traversée 140. Le moyen de détection est formé par la coopération de la mise en pression initiale du corps de pénétration 105 et un détecteur de pression 181 aboutissant dans une chambre interne 182 de la cellule de détection de de raccordement 180.

Ainsi, le détecteur de pression 181 détecte toutes montées en pression à l'intérieur de cette chambre interne 182 traduisant une perte d'herméticité d'une traversée unitaire 123. Le corps de pénétration 105 est avantageusement mis en pression lors de la conception avec un gaz neutre (par exemple l'azote), typiquement sous une pression de 1 MPa à 10 MPa.

Ainsi, grâce à l'architecture de l'assemblage de pénétration électrique 100 selon l'invention, et contrairement à l'état de la technique, la défaillance du connecteur étanche interne 130, ne conduit pas à une brèche du liquide primaire. Ceci est permis par la présence d'une double herméticité, par la présence de moyens de détection de défaillance d'étanchéité de l'assemblage de pénétration électrique 100 et par la présence de de traversées électriques 123 isolées unitairement présentant une architecture assurant la non éjection du conducteur en cas de défaillance de l'isolant unitaire 142. De plus, la caractère individuel des traversées unitaires 123 permet également de limiter les conséquences de leur éventuelle défaillance par la limitation du diamètre de fuite primaire en sortie de la pénétration électrique 100 (typiquement inférieur à 10mm de diamètre) de manière à répondre aux exigences de sureté et permettre d'assurer une continuité de la seconde barrière de confinement.

Les différents composants de l'assemblage de pénétration électrique 100 décrits précédemment sont assemblés de manière indissociable (par exemple par soudure) pour constituer une pénétration électrique monobloc.

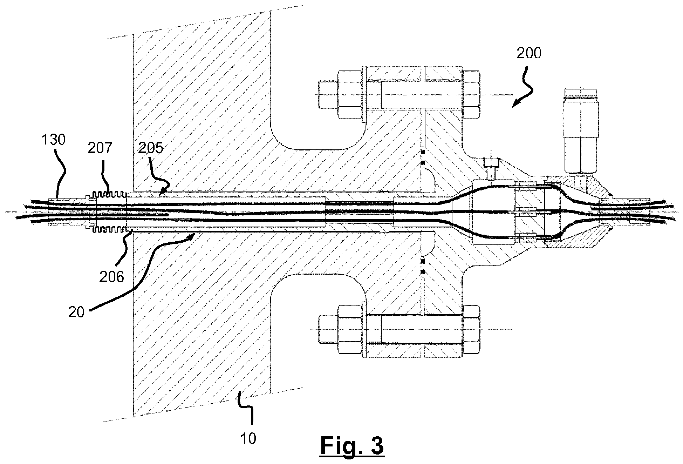

La figure 3 illustre un deuxième mode de réalisation d'une traversée électrique 200 d'une cuve de réacteur nucléaire selon l'invention.

Ce mode de réalisation est identique au premier mode de réalisation décrit précédemment à l'exception de ce qui va être décrit ci-après.

Dans ce second mode de réalisation, le corps de pénétration 205 présente une partie rigide 206 au niveau de l'orifice 20 de la cuve et une partie souple 207 ou plus exactement flexible (par exemple dans le sens longitudinal de la traversée 200) permettant un accostage avec un aboutissant et la compensation des dilatations différentielles. De manière identique au premier mode de réalisation présenté ci-dessus, la partie flexible 207 n'est pas réputée être située sur la seconde barrière de confinement réglementaire.

L'invention a été particulièrement décrite en solidarisant l'assemblage de pénétration électrique par l'extérieur de la cuve 10. Toutefois, il est également envisagé de solidariser l'assemblage de pénétration électrique selon l'invention par l'intérieur de la cuve 10.

## Revendications

1. Assemblage de pénétration électrique (100) de cuve d'un réacteur nucléaire apte à être installé dans un orifice (20) de cuve (10) de réacteur nucléaire, ledit assemblage de pénétration électrique (100) comportant:
- un corps de pénétration (105) comportant :
- une première extrémité (110) apte à être positionnée à l'intérieur de la cuve ;
- une deuxième extrémité (120) apte à être positionnée à l'extérieur de la cuve ;
- un connecteur électrique étanche (130) formant une première herméticité de l'assemblage de pénétration électrique (100), ledit connecteur électrique étanche (130) rendant hermétique le corps de pénétration (105) au niveau de la première extrémité (110);
**caractérisé en ce que** ledit assemblage de pénétration életrique (100) comprend en outre:
- une bride porte-traversées (140) comportant une pluralité de traversées électriques unitaires (123), chaque traversée électrique unitaire (123) permettant le passage d'un unique conducteur électrique (160) assurant la continuité des liaisons électriques, chaque traversé électrique unitaire (123) étant isolée unitairement par un isolant individuel (142) formant une deuxième herméticité de l'assemblage de pénétration électrique, lesdites traversées électriques unitaires (123) rendant hermétique le corps de pénétration (105) au niveau de la deuxième extrémité (120) ;
- un dispositif d'anti-éjection formé par la coopération d'un étranglement (141) ménagé au niveau de chaque traversée électrique unitaire (123) et d'un épaulement (151) présentant des dimensions supérieures aux dimensions de l'étranglement (141) de chaque traversée électrique unitaire (123) et ménagé sur chacun des conducteurs électriques (160) desdites traversées unitaires (123).

2. Assemblage de pénétration électrique (100) de cuve d'un réacteur nucléaire selon la revendication précédente **caractérisé en ce qu'**il comporte des moyens (170, 171) pour solidariser de manière étanche l'assemblage de pénétration électrique (100) à l'extérieur de ladite cuve du réacteur.

3. Assemblage de pénétration électrique (100) de cuve d'un réacteur nucléaire selon l'une des revendications précédentes **caractérisé en ce que** lesdits isolants individuels (142) sont des isolants en céramique ou en vitrocéramique précontrainte.

4. Assemblage de pénétration électrique (100) de cuve d'un réacteur nucléaire selon la revendication précédente **caractérisé en ce que** ledit connecteur électrique étanche (130) est un connecteur électrique présentant un isolant en céramique ou un isolant en vitrocéramique précontrainte.

5. Assemblage de pénétration électrique (100) de cuve d'un réacteur nucléaire selon la revendication précédente **caractérisé en ce que** le matériau de l'isolant du connecteur électrique étanche (130) est différent du matériau formant les isolants individuels (142).

6. Assemblage de pénétration électrique (100) de cuve d'un réacteur nucléaire selon l'une des revendications précédentes **caractérisé en ce qu'**il comporte des moyens pour détecter une défaillance d'étanchéité des traversées unitaires (123).

7. Assemblage de pénétration électrique (100) de cuve d'un réacteur nucléaire selon la revendication précédente **caractérisé en ce que** le corps de pénétration électrique (105) est sous pression d'un gaz neutre et **en ce que** les moyens pour détecter une défaillance d'étanchéité sont formés par un dispositif de détection (181) détectant une augmentation de pression en aval des traversées unitaires (123).

8. Assemblage de pénétration électrique (100) de cuve d'un réacteur nucléaire selon l'une des revendications précédentes **caractérisé en ce que** le corps de pénétration (105) comporte au moins une partie rigide et une partie flexible apte à se déformer au moins selon une direction.

9. Assemblage de pénétration électrique (100) de cuve d'un réacteur nucléaire selon l'une des revendications précédentes **caractérisé en ce que** l'assemblage de pénétration électrique (100) comporte des moyens (106, 141) pour limiter le débit de fuite en cas de défaillance du connecteur électrique étanche (130) cumulée avec la défaillance d'au moins un isolant individuel (142).

10. Assemblage de pénétration électrique (100) de cuve d'un réacteur nucléaire selon la revendication 9 **caractérisé en ce que** l'assemblage de pénétration électrique (100) comporte un premier moyen pour limiter le débit de fuite, en cas de défaillance du connecteur électrique étanche (130) cumulé à la défaillance d'au moins un isolant individuel (142), formé par ledit dispositif anti-éjection (141, 151) ménagé au niveau de chacune des traversées électriques unitaires (123).

11. Assemblage de pénétration électrique (100) de cuve d'un réacteur nucléaire selon l'une des revendications 9 à 10 **caractérisé en ce que** l'assemblage de pénétration électrique (100) comporte un deuxième moyen pour limiter le débit de fuite, en cas de défaillance du connecteur électrique étanche (130) et de plusieurs traversées électrique unitaires (123), formé par une pluralité de conduits unitaires (106) ménagés à l'intérieur du corps de pénétration (105), chaque conduit unitaire (106) étant adapté pour permettre le passage d'un unique conducteur électrique (150) traversant ledit corps de pénétration (105).

12. Cuve de réacteur nucléaire **caractérisée en ce qu'**elle comporte au moins une traversée électrique selon l'une des revendications précédentes.

13. Réacteur nucléaire **caractérisé en ce qu'**il comporte une cuve selon la revendication précédente.

14. Réacteur nucléaire selon la revendication précédente **caractérisé en ce qu'**il comporte des moyens pour détecter une défaillance d'étanchéité du connecteur électrique étanche (130) par contrôle de l'isolement des conducteurs électriques (150, 160) par rapport à la masse.

15. Réacteur nucléaire selon la revendication précédente **caractérisé en ce que** ledit réacteur nucléaire est un réacteur intégré ou un petit réacteur modulaire.

## Patentansprüche

1. Elektrische Eindringgruppe (100) des Beckens eines Kernreaktors, die geeignet ist, in einer Öffnung (20) des Beckens (10) des Kernreaktors eingebaut zu sein, wobei die genannte elektrische Eindringgruppe (100) umfasst:
- einen Penetrationskörper (105), umfassend:
- ein erstes Ende (110), das geeignet ist, im Innern des Beckens positioniert zu sein;
- ein zweites Ende (120), das geeignet ist, außerhalb des Beckens positioniert zu sein;
- einen wasserdichten elektrischen Steckverbinder (130), der eine erste Abgeschlossenheit der elektrischen Eindringgruppe (100) bildet, wobei der genannte wasserdichte elektrische Steckverbinder (130) den Eindringkörper (105) am ersten Ende (110) hermetisch macht;
**dadurch gekennzeichnet, dass** die genannte elektrische Eindringgruppe (100) darüber hinaus umfasst:
- einen Durchquerungs-Flanschträger (140), der eine Vielzahl von elektrischen Einheitsdurchquerungen (123) umfasst, wobei jede elektrische Einheitsdurchquerung (123) den Durchgang eines einzigen elektrischen Leiters (160) zulässt, der die Kontinuität der elektrischen Verbindungen gewährleistet, wobei jede elektrische Einheitsdurchquerung (123) einheitlich durch einen individuellen Isolator (142) isoliert ist, der eine zweite Abgeschlossenheit der elektrischen Eindringgruppe bildet, wobei die genannten elektrischen Einheitsdurchquerungen (123) den Eindringkörper (105) an dem zweiten Ende (120) hermetisch machen;
- eine Anti-Auswurfvorrichtung, die durch das Zusammenwirken einer Verengung (141) geformt ist, die an jeder elektrischen Einheitsdurchquerung (123) ausgespart ist, und einen Ansatz (151), der größere Abmessungen als die Abmessungen der Verengung (141) jeder elektrischen Einheitsdurchquerung (123) aufweist und auf jedem der elektrischen Leiter (160) der genannten elektrischen Einheitsdurchquerungen (123) ausgespart ist.

2. Elektrische Eindringgruppe (100) des Beckens eines Kernreaktors gemäß dem voranstehenden Anspruch, **dadurch gekennzeichnet, dass** sie Mittel (170, 171) umfasst, um die elektrische Eindringgruppe (100) fest außerhalb des genannten Beckens des Reaktors zu verbinden.

3. Elektrische Eindringgruppe (100) des Beckens eines Kernreaktors gemäß irgendeinem der voranstehenden Ansprüche, **dadurch gekennzeichnet, dass** die genannten individuellen Isolatoren (142) Isolatoren aus Keramik oder aus vorgespannter Glaskeramik sind.

4. Elektrische Eindringgruppe (100) des Beckens eines Kernreaktors gemäß dem voranstehenden Anspruch, **dadurch gekennzeichnet, dass** der genannte wasserdichte elektrische Steckverbinder (130) ein elektrischer Steckverbinder ist, der einen Isolator aus Keramik oder einen Isolator aus vorgespannter Glaskeramik aufweist.

5. Elektrische Eindringgruppe (100) des Beckens eines Kernreaktors gemäß dem voranstehenden Anspruch, **dadurch gekennzeichnet, dass** das Material des Isolators des wasserdichten elektrischen Steckverbinders (130) unterschiedlich von dem Material ist, das die individuellen Isolatoren (142) formt.

6. Elektrische Eindringgruppe (100) des Beckens eines Kernreaktors gemäß einem der voranstehenden Ansprüche, **dadurch gekennzeichnet, dass** sie Mittel zum Detektieren eines Ausfalls der Dichtigkeit der Einheitsdurchquerungen (123) umfasst.

7. Elektrische Eindringgruppe (100) des Beckens eines Kernreaktors gemäß dem voranstehenden Anspruch, **dadurch gekennzeichnet, dass** der elektrische Eindringkörper (105) mit einem neutralen Gas mit Druck beaufschlagt ist und dass die Mittel zum Detektieren eines Ausfalls der Dichtigkeit durch eine Detektionsvorrichtung (181) geformt sind, die einen Druckanstieg vor den Einheitsdurchquerungen (123) detektieren.

8. Elektrische Eindringgruppe (100) des Beckens eines Kernreaktors gemäß einem der voranstehenden Ansprüche, **dadurch gekennzeichnet, dass** der Eindringkörper (105) wenigstens einen steifen Teil und einen flexiblen Teil umfasst, der geeignet ist, sich wenigstens gemäß einer Richtung zu verformen.

9. Elektrische Eindringgruppe (100) des Beckens eines Kernreaktors gemäß einem der voranstehenden Ansprüche, **dadurch gekennzeichnet, dass** die elektrische Eindringgruppe (100) Mittel (106, 141) zum Begrenzen des Leckdurchsatzes bei einem Ausfall des wasserdichten elektrischen Steckverbinders (130) umfasst, der mit dem Ausfall wenigstens eines individuellen Isolators (142) angefallen ist.

10. Elektrische Eindringgruppe (100) des Beckens eines Kernreaktors gemäß Anspruch 9, **dadurch gekennzeichnet, dass** die elektrische Eindringgruppe (100) ein erstes Mittel zum Begrenzen des Leckdurchsatzes bei einem Ausfall des wasserdichten elektrischen Steckverbinders (130) umfasst, der mit dem Ausfall wenigstens eines individuellen Isolators (142) angefallen ist, der durch die genannte Anti-Ausstoßvorrichtung (141, 151) geformt ist, der an jeder elektrischen Einheitsdurchquerung (123) ausgespart ist.

11. Elektrische Eindringgruppe (100) des Beckens eines Kernreaktors gemäß Anspruch 9 bis 10, **dadurch gekennzeichnet, dass** die elektrische Eindringgruppe (100) ein zweites Mittel zum Begrenzen des Leckdurchsatzes bei einem Ausfall des wasserdichten elektrischen Steckverbinders (130) und mehrere elektrische Einheitsdurchquerungen (123) umfasst, das durch eine Vielzahl von Einheitsleitungen (106) gebildet ist, die im Innern des Eindringkörpers (105) gebildet sind, wobei jede Einheitsleitung (106) geeignet ist, um den Durchgang eines elektrischen Einheitsleiters (150) zu erlauben, der den genannten Eindringkörper (105) durchquert.

12. Becken eines Kernreaktors, **dadurch gekennzeichnet, dass** es wenigstens eine elektrische Durchquerung gemäß einem der voranstehenden Ansprüche umfasst.

13. Kernreaktor, **dadurch gekennzeichnet, dass** er ein Becken gemäß dem voranstehenden Anspruch umfasst.

14. Kernreaktor gemäß dem voranstehenden Anspruch, **dadurch gekennzeichnet, dass** er Mittel zum Detektieren eines Ausfalls der Dichtigkeit des wasserdichten elektrischen Steckverbinders (130) per Kontrolle der Isolierung der elektrischen Leiter (150, 160) im Verhältnis zur Masse umfasst.

15. Kernreaktor gemäß dem voranstehenden Anspruch, **dadurch gekennzeichnet, dass** der genannte Kernreaktor ein integrierter Reaktor oder ein kleiner modularer Reaktor ist.

## Claims

1. Electrical penetration assembly (100) for a nuclear reactor vessel that can be mounted in an aperture (20) of a nuclear reactor vessel (10), said electrical penetration assembly (100) comprising:
- a penetration body (105) comprising:
- a first end (110) suitable for being positioned inside the vessel;
- a second end (120) suitable for being positioned outside the vessel;
- a sealed electrical connector (130) forming a first seal for the electrical penetration assembly (100), said sealed electrical connector (130) hermetically sealing the penetration body (105) at the first end (110);
Wherein said electrical penetration assembly (100) comprises:
- a feed-through carrier flange (140) comprising a plurality of unitary electrical feed-throughs (123), each unitary electrical feed-through (123) allowing a single electrical conductor (160) to pass therethrough thereby ensuring the continuity of the electrical connections, each unitary electrical feed-through (123) being individually insulated by an individual insulator (142) forming a second seal for the electrical penetration assembly, said unitary electrical feed-throughs (123) hermetically sealing the penetration body (105) at the second end (120);
- an anti-ejection device formed by the engagement between a narrowed portion (141) provided at each unitary electrical feed-through (123) and a shoulder (151) that is larger in size than the narrowed portion (141) of each unitary electrical feed-through (123) and provided on each of the electrical conductors (160) of said unitary feed-throughs (123).

2. Electrical penetration assembly (100) for a nuclear reactor vessel according to the preceding claim **characterised in that** it comprises means (170, 171) for making the electrical penetration assembly (100) integral, in a leak-tight manner, with the outside of said reactor vessel.

3. Electrical penetration assembly (100) for a nuclear reactor vessel according to one of the preceding claims **characterised in that** said individual insulators (142) are insulators made of ceramic or prestressed vitroceramic.

4. Electrical penetration assembly (100) for a nuclear reactor vessel according to the preceding claim **characterised in that** said sealed electrical connector (130) is an electrical connector having an insulator made of ceramic or an insulator made of prestressed vitroceramic.

5. Electrical penetration assembly (100) for a nuclear reactor vessel according to the preceding claim **characterised in that** the material of the insulator of the sealed electrical connector (130) is different from the material forming the individual insulators (142).

6. Electrical penetration assembly (100) for a nuclear reactor vessel according to one of the preceding claims **characterised in that** it comprises means for detecting a leak-tightness failure of the unitary feed-throughs (123).

7. Electrical penetration assembly (100) for a nuclear reactor vessel according to the preceding claim **characterised in that** the electrical penetration body (105) is pressurised by an inert gas and **in that** the means for detecting a leak-tightness failure are formed by a detection device (181) detecting an increase in pressure downstream of the unitary feed-throughs (123).

8. Electrical penetration assembly (100) for a nuclear reactor vessel according to one of the preceding claims **characterised in that** the penetration body (105) comprises at least one rigid part and one flexible part capable of deforming at least along one direction.

9. Electrical penetration assembly (100) for a nuclear reactor vessel according to one of the preceding claims **characterised in that** the electrical penetration assembly (100) comprises means (106, 141) for limiting the leakage rate in the event of failure of the sealed electrical connector (130) combined with the failure of at least one individual insulator (142).

10. Electrical penetration assembly (100) for a nuclear reactor vessel according to claim 9 **characterised in that** the electrical penetration assembly (100) comprises a first means for limiting the leakage rate, in the event of failure of the sealed electrical connector (130) combined with the failure of at least one individual insulator (142), formed by said anti-ejection device (141, 151) provided at each of the unitary electrical feed-throughs (123).

11. Electrical penetration assembly (100) for a nuclear reactor vessel according to one of claims 9 to 10 **characterised in that** the electrical penetration assembly (100) comprises a second means for limiting the leakage rate, in the event of failure of the sealed electrical connector (130) and of several unitary electrical feed-throughs (123), formed by a plurality of unitary ducts (106) provided inside the penetration body (105), each unitary duct (106) being suitable for allowing a single electrical conductor (150) to pass therethrough going through said penetration body (105).

12. Nuclear reactor vessel **characterised in that** it comprises at least one electrical feed-through according to one of the preceding claims.

13. Nuclear reactor **characterised in that** it comprises a vessel according to the preceding claim.

14. Nuclear reactor according to the preceding claim **characterised in that** it comprises means for detecting a leak-tightness failure of the sealed electrical connector (130) by control of the insulation of the electrical conductors (150, 160) with respect to earth.

15. Nuclear reactor according to the preceding claim **characterised in that** said nuclear reactor is an integrated reactor or a small modular reactor.
